## Europäisches Patentamt
## European Patent Office
## Office européen des brevets

(19)

(11) Publication number: **0 023 130**
**B1**

(12) **EUROPEAN PATENT SPECIFICATION**

(45) Date of publication of patent specification: **21.03.84**

(51) Int. Cl.³: **H 01 L 29/743**

(21) Application number: **80302402.5**

(22) Date of filing: **17.07.80**

(54) Semiconductor switch.

(30) Priority: **20.07.79 JP 91524/79**

(43) Date of publication of application:
**28.01.81 Bulletin 81/4**

(45) Publication of the grant of the patent:
**21.03.84 Bulletin 84/12**

(84) Designated Contracting States:
**DE FR GB SE**

(56) References cited:
**DE - A - 2 655 622**
**FR - A - 2 412 169**
**US - A - 4 015 143**

**PATENT ABSTRACTS OF JAPAN, vol. 2, no. 37,
13th March 1978, page 27E78 Tokyo, JP**
**PATENT ABSTRACTS OF JAPAN, vol. 2, no. 26,
20th February 1978, page 11924E77 Tokyo, JP**
**PATENT ABSTRACTS OF JAPAN, vol. 1, no. 66,
27th June 1977, page 360E77 Tokyo, JP**

(73) Proprietor: **Hitachi, Ltd.**
**5-1, Marunouchi 1-chome**
**Chiyoda-ku Tokyo 100 (JP)**

(72) Inventor: **Suzuki, Masayoshi**
**3233-4 Uchibori**
**Hitachiota-shi (JP)**
Inventor: **Sagawa, Akio**
**2379-78 Okubocho**
**Hitachi-shi (JP)**

(74) Representative: **Paget, Hugh Charles Edward et al,**
**MEWBURN ELLIS & CO. 2/3 Cursitor Street**
**London EC4A 1BQ (GB)**

(56) References cited:
**PATENT ABSTRACTS OF JAPAN, VOL. 1, NO.
81, 28TH JULY 1977, PAGE 1531E77, TOKYO,
JP**
**BOOK: "BIPOLAREN TRANSISTORERS", PAGES
102-105**

Semiconductor switch

The present invention relates to a semiconductor switch using a PNPN switching element.

In general a semiconductor switch of four-layer structure or the like may be turned on erroneously when a forward voltage is suddenly applied across the semiconductor switch (between anode and cathode) even when it is in the cutoff state. This is called the rate effect and its minimum strength sufficient for misfiring the thyristor called the dv/dt firing capability.

To prevent this erroneous turning-on, a resistor (of resistance $R_{GK}$) is connected between the gate and cathode of the PNPN four-layer switching element (hereinafter referred to as the thyristor). This short-circuiting is referred to as "short-emitter".

In order to improve the dv/dt firing capability of the thyristor by this method, it is necessary to reduce the resistance of the resistor. This results in an inevitable decrease in the gate sensitivity of the thyristor. In other words, if the resistance $R_{GK}$ is decreased, the displacement current flowing through the junction capacitance between the cathode and anode when a noise voltage is applied therebetween flows almost entirely in the resistor with the result that the voltage between the gate and cathode does not exceed the built-in voltage (about 0.7 V) of the thyristor thereby to prevent erroneous operation thereof. However, when turning on the thyristor, the firing current from the gate again flows almost entirely into the resistor and thus the current necessary for turning-on the thyristor increases.

Then if the resistance value $R_{GK}$ is reduced in order to achieve increase in stability of the thyristor against noise, the gate firing current is increased thereby to reduce the sensitivity of the thyristor. This is undesirable in that the power required for firing the thyristor increases.

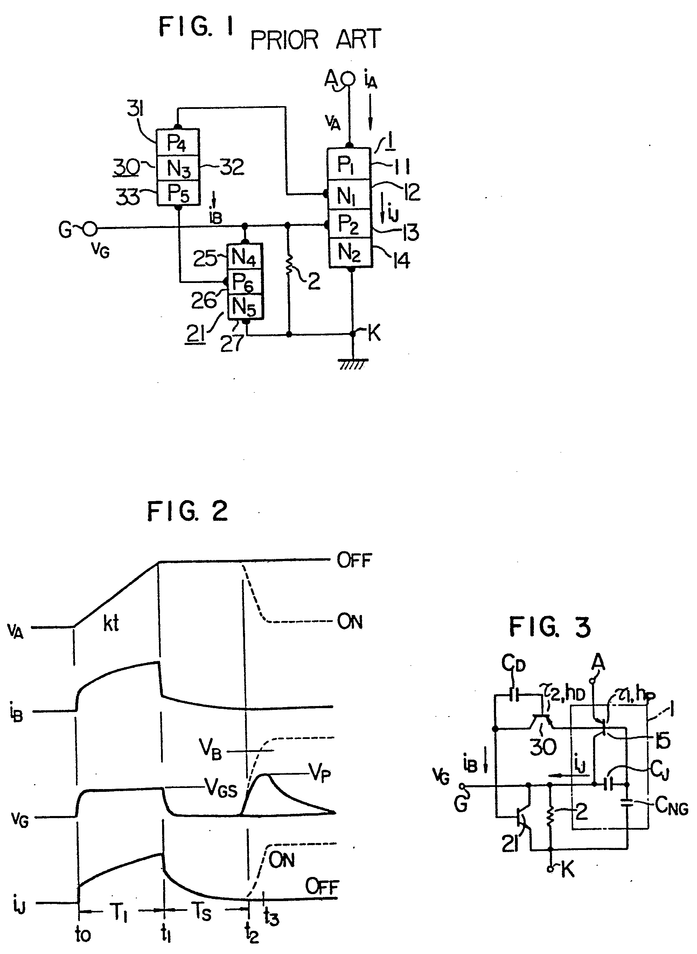

Therefore, it is desirable to provide a thyristor circuit with a small gate firing current and with a good dv/dt firing capability (i.e. high in a firing voltage between the anode and cathode of the thyristor), and to achieve this the circuit arrangement as shown in Figure 1 has been proposed.

Such circuit is disclosed in the "Semiconductor switch" of U.S. Application Serial No. 556326 by Michio Tokunaga et al which was filed on March 7, 1975, issued on March 29, 1977 as U.S. Patent No. 4015143. This shows a semiconductor switch comprising:

a thyristor (1) comprising four semiconductor layers PNPN having three PN junctions and anode, cathode and gate electrodes;

a first bipolar transistor (21, 70) for short circuiting the PN junction between one of the outer semiconductor layers and the adjacent intermediate layer of the thyristor upon saturation of the first bipolar transistor; and

a second bipolar transistor provided between the base of the first bipolar transistor and the intermediate layer adjacent said other outer layer of the thyristor so as to saturate said first transistor in accordance with the voltage which is applied to said other outer layer of the thyristor and which increases the potential of the anode relative to the cathode.

In the circuit of Figure 1 of the accompanying drawings, a transistor 21 is connected between the gate G and cathode K of a thyristor 1, and a bipolar transistor 30 between the base of the bipolar transistor 21 and a N-base 11 of the thyristor 1.

The thyristor 1 is of the four layer structure of P-type emitter ($P_1$), 11, N-type emitter ($N_2$) 14, N-type base ($N_1$) 12, and P-type base ($P_2$) 13, and is turned on by the gate G of the P-type base 13.

The bipolar transistor 21 is formed by an N-type collector ($N_4$) 25, a P-type base ($P_6$) 26 and an N-type emitter ($N_5$) 27. The bipolar transistor 30 is formed by a P-type emitter ($P_4$) 31, an N-type base ($N_3$) 32, a P-type collector ($P_5$) 33.

In the circuit of Figure 1, when a noise voltage pulse is applied to the anode A of the thyristor 1, the transient voltage is differentiated by the capacitance of the collector-base junction of the bipolar transistor 30, and the current obtained from this differentiation drives the bipolar transistor 21. Simultaneously, the bipolar transistor 21 is brought into saturation from the nonconducting state, short-circuiting the path between the gate G and cathode K of the thyristor 1. The collector-emitter shunt resistance of the bipolar transistor 21 in this case can be considerably reduced as compared with the value of a resistor 2, thereby improving the dv/dt firing capability.

If noise voltage pulse is not applied to the anode A the bipolar transistor 21 is in the cutoff (nonconducting) state, and thus the resistance between the gate G and cathode K is only the value $R_{GK}$ of the resistor 2. The resistance $R_{GK}$ can be selected to be relatively high (enough to absorb the leak current in the thyristor due to temperature), and thus contributes to a low gate firing current.

The operation of the circuit of Figure 1 will now be described briefly. Figure 2 shows the voltage and current waveforms of each part when the thyristor 1 as shown in Figure 1 is supplied at its anode A with a noise voltage $v_A$ of a ramp shape (the rising slope is constant). In Figure 2, $i_J$ represents the current flowing through the thyristor 1, $i_B$ the current through the transistor 30 and $v_G$ the gate voltage of the thyristor 1. Figure 3 is an equivalent circuit of the circuit of Figure 1. The circuit of Figure 3 includes a PNP bipolar transistor 15 consisting of $P_1$, $N_1$ and $P_2$ of the thyristor 1, a second junction capacitance $C_J$ and an N base-ground capacitance $C_{NG}$ of the thyristor. Reference characters $h_P$ and $h_D$ represent current amplification factors of bipolar transistors 15 and 30, respectively $\tau_1$ and $\tau_2$ fall time constants of the bipolar transistors 15 and 30, respectively, and k is the slope rate of the ramp voltage.

At time $t_0$, when the noise voltage pulse $v_A$ has started to rise most of the noise voltage is applied between the electrodes $(N_1)$ 12 and $(P_2)$ 13 of the thyristor 1 and between the electrodes $(N_3)$ 32 and $(P_5)$ 33 of the bipolar transistor 30. The other PN junctions are not supplied with the noise voltage because they are forward biased. If the capacitance of the PN junctions $(N_3P_5)$ of the transistor 30 is taken as $C_D$, the current $i_J$ flowing through the junction between the electrodes $(N_1)$ 12 and $(P_2)$ 13 of the thyristor 1 and the current $i_B$ flowing through the bipolar transistor 30 are given by

$$i_J = C_J \frac{dv}{dt} \qquad (1)$$

$$i_B = C_D \frac{dv}{dt} \qquad (2)$$

where v represents the voltage applied to the PN junctions and is substantially equal to the voltage $v_A$. Since the voltage $v_A$ has a ramp shape during the period ($t_0$ to $t_1$) as shown in Figure 2, the dv/dt value is constant K ($v=v_A=kt$). Thus, the currents $i_J$ and $i_B$ are rewritten as

$$i_J = C_J k \qquad (3)$$

$$i_B = C_D k \qquad (4)$$

When these currents are generated, the bipolar transistor 21 is instantly turned on to be in saturation, with the result that most of the transient current $i_J$ from the thyristor 1 flows into the collector of the transistor 21. Thus, the value $V_{GS}$ of the voltage $v_G$ at the gate G is reduced to as little as the collector-emitter saturation voltage and lower than the gate-cathode conducting voltage $V_B$ of the thyristor. Therefore, during the period, erroneous firing due to the noise voltage pulse does not occur.

The currents $i_J$ and $i_B$ expressed by Eqs. (3) and (4) are displacement currents flowing through the PN junctions, and permit small conducting currents to flow through the thyristor 1 and the bipolar transistor 30. During the period $T_1$ ($t_0$ to $t_1$), the PNP transistor of the structure $P_1N_2P_2$ becomes active in the thyristor 1.

The base current of the PNP bipolar transistor $(P_1N_1P_2)$, i.e. the current flowing through the N base 12, is the sum of the currents $i_J$ and $i_B$. The conduction current $i_{JD}$ of the thyristor 1 is given by

$$i_{JD} = C_J k h_P (1 - \varepsilon^{-t/\tau_1}) \qquad (5)$$

where $\tau_1$ is a fall time constant of the transistor 15 $(P_1N_1P_2)$ and the reciprocal of a cut-off angular frequency. Also, the conduction current $i_{BD}$ flowing through the bipolar transistor 30 is given by

$$i_{BD} = C_D k h_D (1 - \varepsilon^{-t/\tau_2}) \qquad (6)$$

The values of the currents $i_{JD}$ and $i_{BD}$ are smaller than those of the currents $i_J$ and $i_B$ since $h_D$ is smaller than 1. When the noise voltage pulse reaches its maximum, the currents $i_J$ and $i_B$ are immediately reduced to zero, and only the conducting currents in the thyristor 1 and the bipolar transistor 30 remain at the PN junctions.

If the conduction currents at this time are represented by $I_{JD}$ and $I_{BD}$, they are given by

$$I_{JD} = C_J k h_P (1 - \varepsilon^{-T_1/\tau_1}) \qquad (7)$$

$$I_{BD} = C_D k h_D (1 - \varepsilon^{-T_1/\tau_2}) \qquad (8)$$

After time $t_1$, the current $i_B$ and $i_J$ decrease with time as given by following equations,

$$i_J = I_{JD} \varepsilon^{-t/\tau_1} \qquad (9)$$

$$i_B = I_{BD} \varepsilon^{-t/\tau_2} \qquad (10)$$

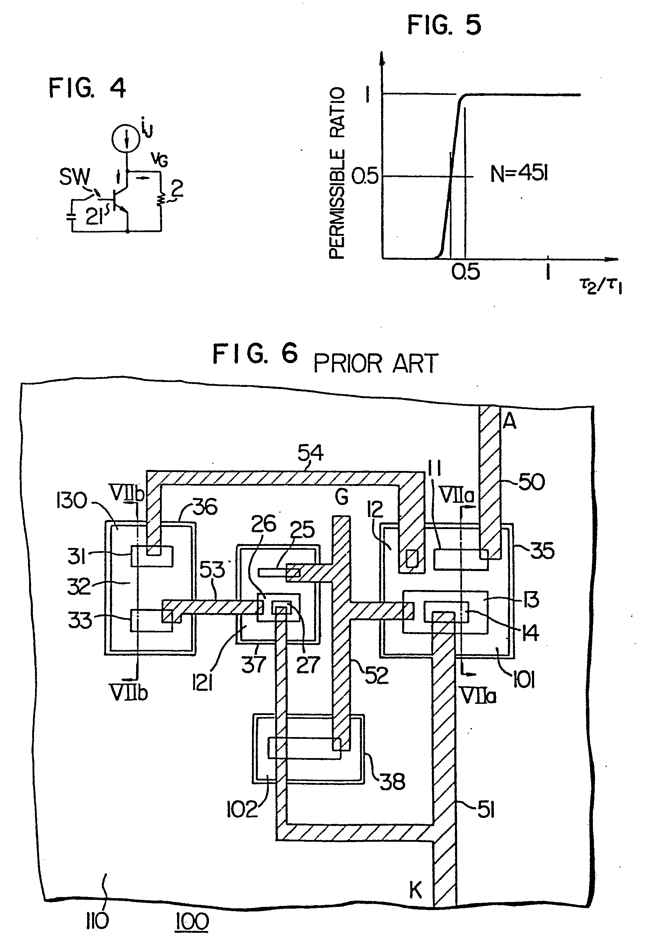

where t shows a period after the time point $t_1$. Even though the transient voltage (noise voltage pulse) has risen at time $t_1$, the bipolar transistor 21 continues to be in saturation, due to the storage effect of carriers in the transistor 21. When the carriers due to the storage effect disappear at time $t_2$, the bipolar transistor 21 becomes active to restore resistivity to its collector junction. This operation can be supposed from the equivalent circuit of Figure 4, and at $t_3$ the switch SW can be considered to open. The period of time $t_1$ to $t_2$ is called a storage time the value of which is represented here by Ts.

If the currents $i_B$ and $i_J$ near the time $t_2$ are represented by $I_B$ and $I_J$ respectively, the currents $I_B$ and $I_J$ are given as follows since the storage effect disappears near the time $t_2$.

$$I_J = I_{JD}^{-Ts/\tau_1} \qquad (11)$$

$$I_B = I_{BD}^{-Ts/\tau_2} \qquad (12)$$

Since the bipolar transistor 21 is in saturation before time $t_2$, the collector-emitter voltage (which equals to the gate voltage $v_G$ of the bipolar transistor 21 is very low. After $t_2$, the current $i_J$ can not flow into the collector of the bipolar transistor 21, but instead flows to the resistor 2, and therefore the peak voltage $v_G$ has a peak as shown in Figure 2. When the peak voltage $V_P$ exceeds the gate-cathode built-in voltage $V_B$ of the thyristor as shown by a dotted line in Figure 2, the thyristor 1 is turned on to vary the voltage $v_A$ and the current $i_J$ is shown by dotted lines in Figure 2. This turning-on is erroneous thereby degrading the reliability of the operation of the element.

The peak value $V_P$ of the gate voltage $v_G$ is given by

$$V_P = (i_J - h_Q i_B)R_{GK} \qquad (13)$$

where $h_Q$ represents the current amplification factor of the bipolar transistor 21. The lower the value of the voltage $v_P$, the wider the voltage difference from the $V_P$ to the $V_B$, so that erroneous firing is usually prevented by selecting suitable values in Eq. (13). Since a decrease of the voltage $V_P$ will decrease the possibility of erroneous firing, it is general practice to decrease the value of $R_{GK}$ or increase the value of $h_Q$. However, decrease of the voltage $V_P$ is limited since the changes of such circuit constants are limited.

From the waveforms of currents $i_J$ and $i_B$ of Figure 2, it will be evident that to reduce the voltage $V_P$, the current $i_J$ needs to be attenuated rapidly and the current $i_B$ needs to flow for a long period of time. To achieve this it has been proposed to change the structure of the semiconductor element (thyristor, bipolar transistor) to give a suitable time constant $\tau_1$ (carrier fall time) of the bipolar transistor formed by layers $P_1N_1P_2$ of the thyristor 1, and the fall time constant $\tau_2$ of the bipolar transistor 30. However, these values are widely changed depending on various conditions, particularly on the external conditions such as temperature, moisture, and the like, so that it is difficult to prevent erroneous turning-on.

DE 2655622 also shows a thyristor in which it is sought to improve the dv/dt firing capability of the thyristor. A bipolar transistor is connected between one of the outer layers and the adjacent inner layer of the thyristor, the base of which transistor is connected to the other intermediate layer via a semiconductor layer of opposite conductivity type to the intermediate layer. However, such a device also suffers from erroneous firing due to a noise voltage applied to the gate.

Moreover, it has been proposed that a new circuit element is added to extend the period during which the current $i_B$ flows, but this proposition has a drawback of complicating the circuit construction.

Now, from the equations (11), (12) and (13), the following equation is obtained.

$$V_P = R_{GX}(I_{JD}\varepsilon^{-Ts/\tau_1} - h_Q I_{BD}\varepsilon^{-Ts/\tau_2}) \qquad (14)$$

It is apparent from this equation that the voltage $V_P$ can be small if $\tau_1$ is made small relative to $\tau_2$.

The present inventors have found from the equation (14) that if the ratio of time constants $\tau_1$ and $\tau_2$ is made greater than a particular value the gate voltage $V_P$ of the thyristor can be restricted to the built-in voltage $V_B$ or below and the variation of $V_P$ can be limited to a minimum value irrespective of the change of various conditions.

The problem of erroneous firing is solved or ameliorated by the present invention by forming the structure of the second bipolar transistor and a third bipolar transistor consisting of said other outer layer and the two intermediate layers of the thyristor such that the ratio of the carrier fall time constant of the second and third bipolar transistors is not substantially less than 0.5, thereby to prevent the semiconductor switch from erroneous firing.

The carrier fall time constant of the third bipolar transistor is hereinafter referred to as the time constant of the thyristor.

Furthermore, the plane diffused pattern of the emitter and collector of the third bipolar transistor may be made substantially identical in location and/or spacing to that of the second bipolar transistor. If this is done, the characteristics of the thyristor and second transistor (for example time constants $\tau_1$ and $\tau_2$) can be adjusted by a known amount upon change of conditions and the variation of voltage $V_P$ may be made as small as possible. This also helps to ensure that the thyristor is not turned on erroneously. Such geometrical variation has been known in connection with other devices. Thus, in JP—A—52 4791 and the corresponding abstract in Patent Abstracts of Japan volume 1, No. 66 27th June 1977, page 360 E77 there is shown a switch element formed by a transistor with a thyristor connected between the base and the collector of the transistor. When the area of the gate of the thyristor is more than 5 times the area of the emitter of the transistor, power is shared by the transistor and thyristor during turn-on and this improved the turn-on time. The ability of the switch to withstand power surges is also improved.

Embodiments of the invention will now be described in detail by way of example with reference to the accompanying drawings in which:

Figure 1 is a circuit diagram of a typical example of a conventional semiconductor switch;

Figure 2 is a waveform diagram of voltages and currents in the circuit of Figure 1 when a transient voltage is applied;

Figure 3 shows an equivalent circuit of the circuit of Figure 1;

Figure 4 shows an equivalent circuit when the circuit is operated;

Figure 5 is a graph showing the relationship between the time constant ratio and the dv/dt firing capability;

Figure 6 is a plan view of a dielectric insulation separating substrate on which the circuit of Figure 1 is integrated by known methods;

Figures 7A and 7B are longitudinal sections taken along lines VIIa—VIIa and VIIb—VIIb of Figure 6, respectively;

Figures 8A and 8B are plan views of a thyristor and a transistor showing one embodiment of the invention;

Figures 9 and 10 are modifications of the

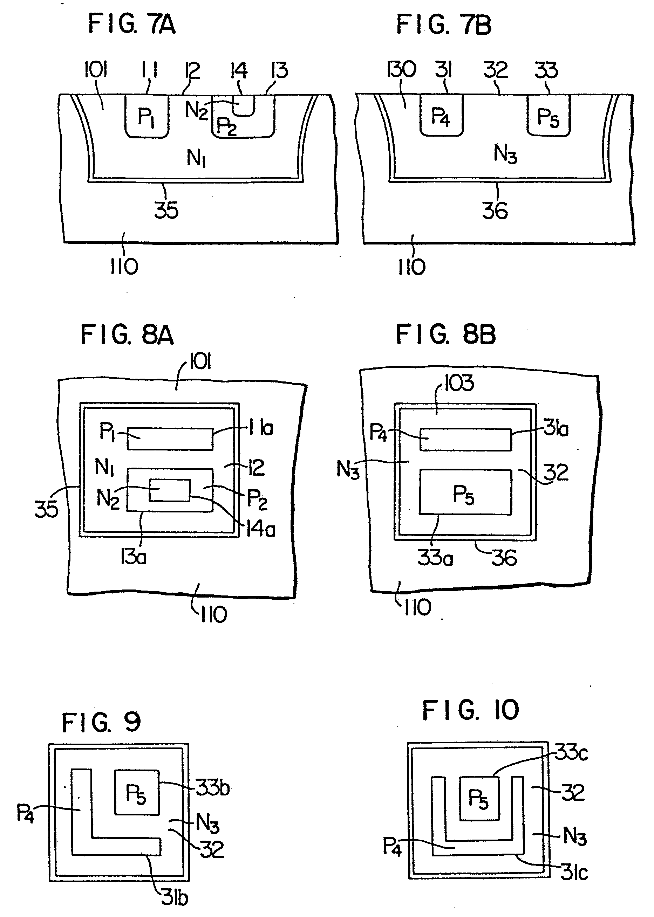

embodiments of Figures 8A and 8B, respectively;

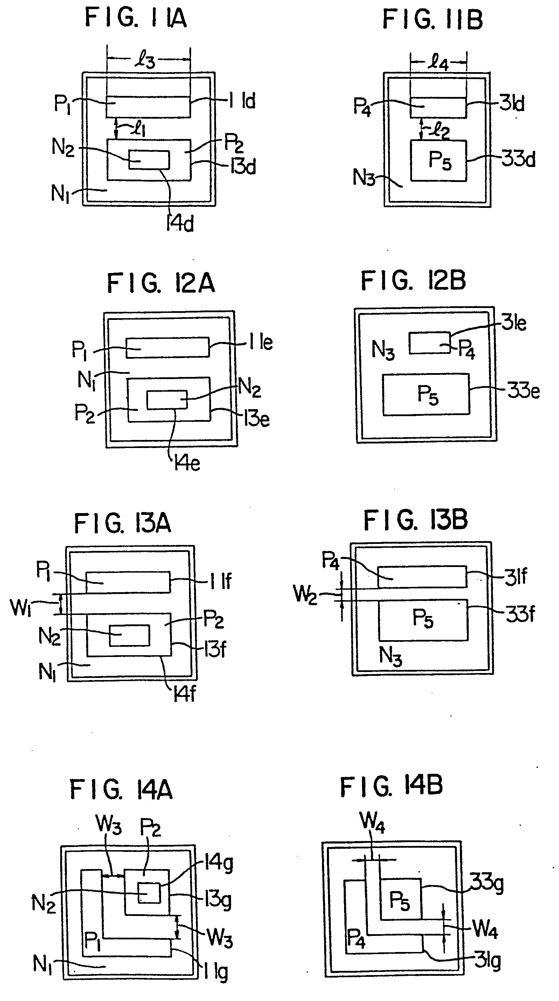

Figures 11A and 11B are another embodiment of the thyristor and transistor according to the invention, respectively;

Figures 12A and 12B are still another embodiment of the thyristor and transistor according to the invention;

Figures 13A, 13B, 14A, 14B, 15A and 15B are plan views of another embodiment of the invention;

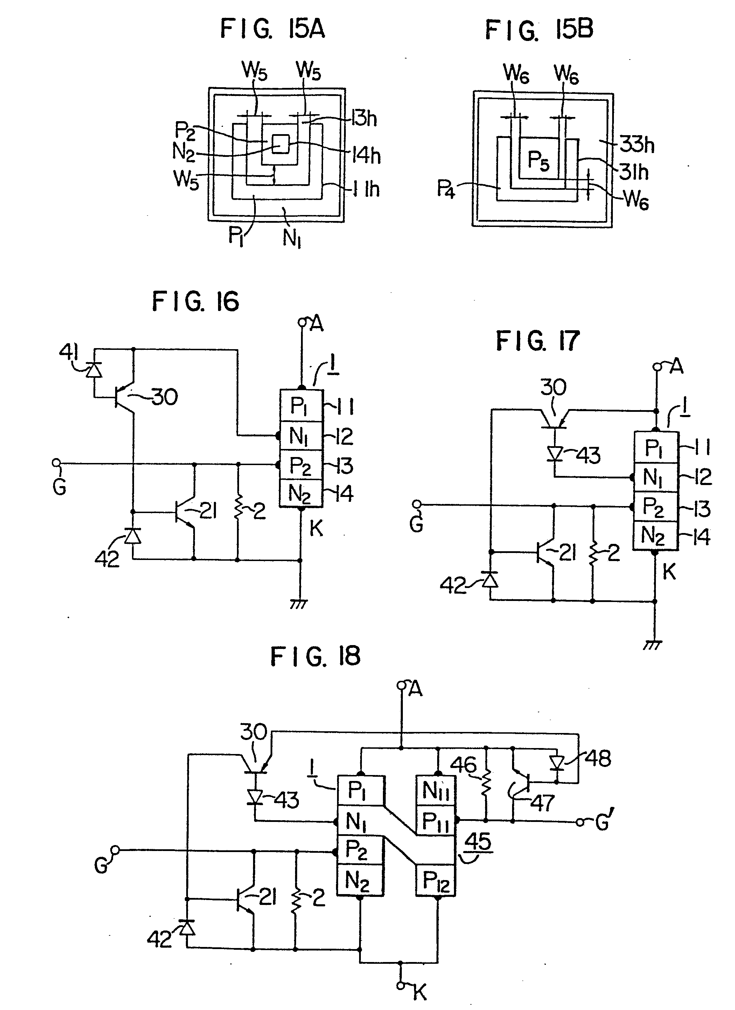

Figures 16, 17 and 18 are circuit diagrams of preferred modifications of the semiconductor switch according to the invention;

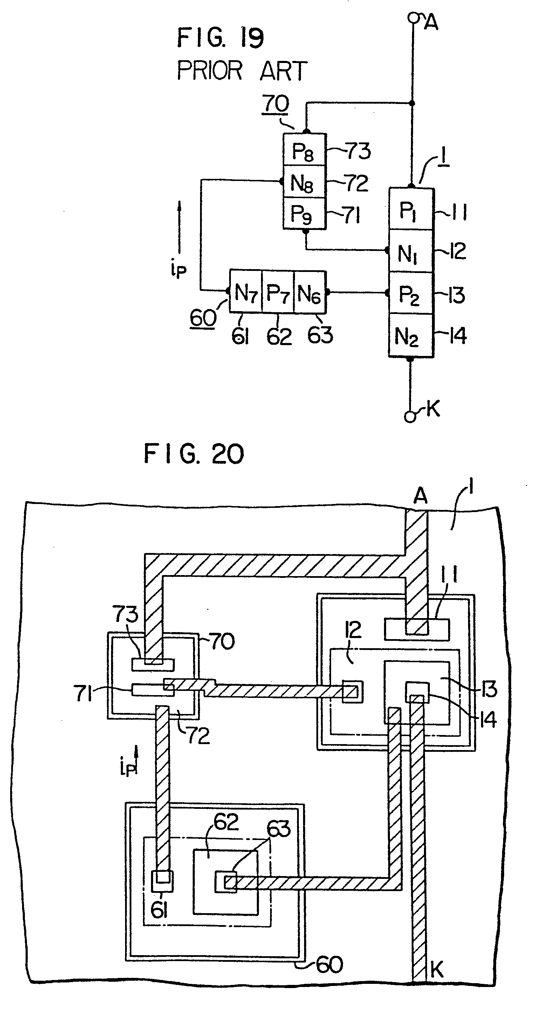

Figure 19 is another short-emitter circuit diagram of the conventional thyristor;

Figure 20 is a plan view of the dielectric isolation separating substrate on which the circuit of Figure 19 is integrated according to the invention;

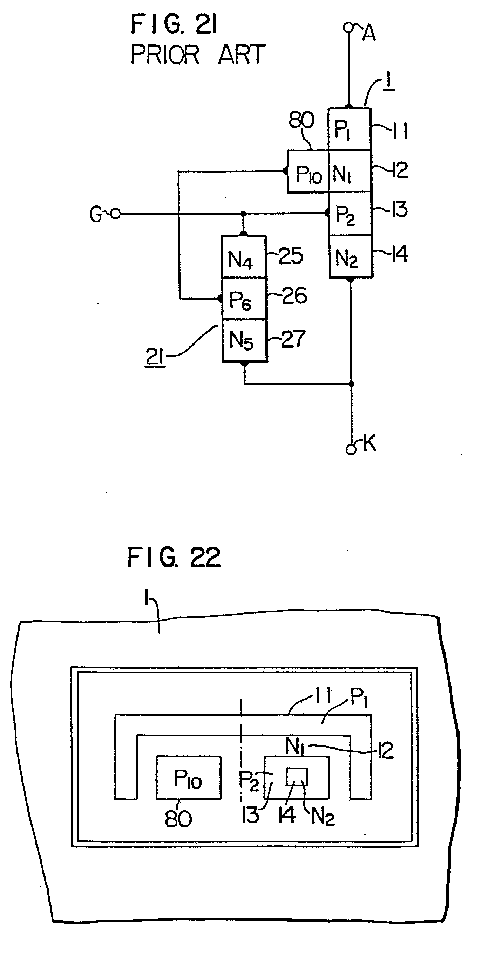

Figure 21 is still another short-emitter circuit diagram of the conventional thyristor; and

Figure 22 is a partial plan view of the dielectric insulation separating substrate on which the circuit of Figure 21 is integrated in accordance with the invention.

The present inventors have found from the equation (14) that if the ratio of time constants $\tau_1$ and $\tau_2$ is brought within a particular range, the gate voltage $V_p$ of the thyristor can be restricted to the built-in voltage $V_B$. In accordance with such a proposal if the plane patterns of the thyristor 1 and the bipolar transistor 30 are similar, the characteristics of the thyristor 1 and the bipolar transistor 30 (for example, time constants, $\tau_1$ and $\tau_2$) can be changed by a predetermined amount upon change of conditions, and the variation of the voltage $V_p$ can be made as small as possible, thereby preventing the thyristor 1 from being turned on erroneously. The inventors have produced a number of monolithic ICs with the circuit of Figure 1 by the widely used bipolar process. The ICs thus produced have different ratio $\tau_2/\tau_1$ of the time constant $\tau_1$ of the thyristor 1 and the time constant $\tau_2$ of the bipolar transistor 30, and the relation between the ratio $\tau_2/\tau_1$ and the gate voltage $V_p$ has been confirmed by experiment. The number of measured elements was 451, and the gate voltage $V_p$ for each $\tau_2/\tau_1$ of each of a plurality of elements was measured. In addition, the proportion of the elements whose gate voltage $V_p$ is lower than the built-in voltage $V_B$ (0.7 V) of the thyristor 1 was examined for each value of $\tau_2/\tau_1$. This proportion is referred to as the permissible ratio. Figure 5 shows the measured results of the permissible ratio. It will be apparent from the figure that the permissible ratio increase when the ratio $\tau_2/\tau_1$ is about 0.4 and becomes 100% when the ratio is almost 0.5 or above. In other words, if the ratio $\tau_2/\tau_1$ is selected to be almost 0.5 or above, erroneous firing of the thyristor 1 can be completely prevented.

On the other hand, if the absolute values of $\tau_2$ and $\tau_1$ are increased to a certain value or above, the thyristor loses its usefulness as a switch and thus the values $\tau_2$ and $\tau_1$ each have upper limits. The time taken to operate a mechanical switch is normally about 1 to 5 milli-seconds and thus the semiconductor switch must have $\tau_2$ and $\tau_1$ shorter than these values of the mechanical switch. Consequently, the absolute values of $\tau_1$ and $\tau_2$ are preferably less than 1 milli-second.

The electronic circuit of Figure 1 is normally integrated as shown in Figure 6. In Figure 6, elements corresponding to those of Figure 1 are identified by the same reference numerals. Figures 7a and 7b are cross-sections of the thyristor 1 and the bipolar transistor 30 as the main components of Figure 6, respectively.

The thyristor 1, resistor 2 and bipolar transistor 21 and 30 are integrated in semiconductor single crystal island regions 101, 102, 121, and 130 of a dielectric insulation separating substrate 100. The island regions are insulated from a semiconductor poly-crystal supporting region 110 by insulating films 35 to 38.

The thyristor 1 as shown in Figures 6 and 7A is of four-layer $P_1N_1P_2N_2$ structure and the transistor 30 is of three-layer $P_4N_3P_5$ structure. The regions $N_1$ and $N_3$ of both the elements are the most fundamental layers, which are electrically insulated in the thyristor 1 and bipolar transistor 30. Electrical signals to the respective elements do not interfere with each other. As shown in Figure 7A, the $N_2$ region 14 is formed in the $P_2$ region 13 by diffusion to complete the $P_1N_1P_2N_2$ structure of the thyristor 101. As shown in Figure 7B, the $P_4$ and $P_5$ regions 31 and 33 are formed in the $N_3$ region by diffusion to complete a PNP element forming bipolar transistor 130.

In Figure 6, interconnection between the elements is achieved by conductors 50, 51, 52, 53 and 54 which are indicated by the hatched areas in Figure 5.

The NPN bipolar transistor 21 is also produced in substantially the same way and the resistor 2 can be produced by diffusing a P-region into the fundamental region. This manufacturing process is the same as the known technique.

In the prior art, in Figure 6, the structure of the thyristor 1 and bipolar transistor 30, particularly the plane pattern (diffused pattern) is not limited in any particular way and the bipolar transistor and thyristor have been designed to conform to a practical pattern structure. For this reason, the characteristics of the thyristor and bipolar transistor (such as time constants) are changed due to the variation of various conditions so that the gate voltage $V_p$ is changed to cause erroneous firing.

The present invention proposes a specific way of bringing the $\tau_2/\tau_1$ ratio within a predetermined range, in which the PNP structure of the thyristor and the PNP structure of the transistor, particularly the diffused pattern of both the elements is designed to be similar, thereby maintaining the variation of the characteristics due to the change of various conditions of the elements at a constant ratio. As a consequence, the gate voltage $V_P$ is kept below the built-in voltage $V_B$ of the thyristor and the variation of $V_P$ is minimized.

As described above, if $\tau_2/\tau_1$ is substantially 0.5 or above, the thyristor can be prevented from erroneous firing. The condition when $\tau_2 \fallingdotseq \tau_1$ can easily be realized for practical production by making the plane patterns of the PNP (11, 12, 13) of the thyristor 1 and the PNP (31, 32, 33) of the transistor 30 similar. Figures 8A and 8B are an embodiment of the present invention, in which the plane pattern of the PNP of the thyristor 1 is made geometrically equal to that of the PNP of the transistor 30 (here, the same shape is referred to as congruence). In other words, the P-type emitters $(P_1)$ 11a and $(P_4)$ 31a of the thyristor 1 and transistor 30 are made to have the same shape, the P-type collectors $(P_2)$ 13a and $(P_5)$ 33a thereof to have the same shape, and the arrangement of the emitter $P_1$ and collector $P_2$ of the thyristor 1 to be the same as that of the emitter $P_4$ and collector $P_5$ of the transistor 30. The depth of the $P_1$ and $P_4$ layers is equal to that of the $P_2$ and $P_5$ layers.

While the emitter and collector patterns of Figures 8A and 8B are of a strip-shape, the emitters may be of L-shape or U-shape as shown in Figures 9 and 10, respectively and the patterns of $P_1$ and $P_2$ may be the same as that of $P_4$ and $P_5$.

Upon making such patterns, the desired physical size of the plane pattern can be formed accurately and easily within 1% error of area ratio or dimensional ratio.

The element structures of the thyristor 1 and transistor 30 are made congruent to have substantially the same values of time constants $\tau_1$ and $\tau_2$ and thus the gate voltage $V_P$ can be decreased to below the built-in voltage $V_B$ of the thyristor gate-cathode junction, thereby restricting variation of the voltage $V_P$. Since the diffusion patterns of the thyristor 1 and transistor 30 are congruent, the time constant $\tau_2$ is increased or decreased by almost the same value with an increase or decrease of the time constant $\tau_1$ due to variation of various conditions, limiting the variation of the peak voltage $V_P$ to a very small value. If the peak voltage $V_P$ is changed only slightly, it can be easily restricted to a certain value or below. Accordingly, by maintaining the $V_P$ at the gate-cathode conduction voltage $V_B$ (about 0.7 V) of the thyristor 1, it is possible to produce a semiconductor switch the operation of which is almost unaffected by noise voltages, and thereby substantially to prevent mis-operation due to variation of characteristics.

The case when $\tau_2/\tau_1 > 0.5$ will be mentioned below. To satisfy the condition $\tau_2/\tau_1 > 0.5$, the plane pattern of the PNP structure of the thyristor 1 should be designed to be similar to that of the bipolar transistor 30. The first approach therefore will be described with reference to Figs. 11A and 11B. Figures 11A and 11B show strip-shaped plane patterns of the emitters and collectors of the thyristor 1 and bipolar transistor 30. The ratio $\tau_2/\tau_1$ can be adjusted by changing only the pattern length of the emitters $(P_1)$ 11d and $(P_4)$ 31d and collectors $(P_2)$ 13d and $(P_5)$ 33d. That is, $\tau_1$ depends on the length $l_3$ of $P_1$ and $P_2$, and $\tau_2$ on the length $l_4$ of $P_4$ and $P_5$. From the experimental results, it was found that if $l_4/l_3 > 0.2$, then $\tau_2/\tau_1 > 0.5$ can be satisfied. In this case, it is assumed that the widths of $P_1$ and $P_4$ are equal, those of $P_2$ and $P_5$ equal and the distance $l_1$ between $P_1$ and $P_2$ of the thyristor 1 is equal to the distance $l_2$ between $P_4$ and $P_5$ of the bipolar transistor 30. In this construction, the emitter $P_4$ and collector $P_5$ of the bipolar transistor 30 can be made small and thus the transistor 30 can be small sized.

While the emitter $P_1$, $P_4$ pattern is of strip-shape here, L-shaped or U-shaped patterns or the like can be used for the emitters in this embodiment.

The second approach for satisfying the condition $\tau_2/\tau_1 > 0.5$ is to choose a suitable ratio between the collector and emitter areas of the plane pattern in each of the thyristor and bipolar transistors. The time constant $\tau_1$ is normally determined by the ratio of the area $S_2$ of the emitter $P_2$ to the area $S_1$ of the collector $P_1$ of the thyristor 1, and the time constant $\tau_2$ by the ratio of the area $S_4$ of the emitter $P_5$ to the area $S_3$ of the collector $P_4$ of the bipolar transistor 30. Thus, as shown in Figures 12a and 12b, the area $S_2$ of the collector $P_2$ of the thyristor 1 as indicated by 13e can be made the same as the area $S_4$ of the collector $P_5$ of the transistor 30, and the ratio of the area $S_3$ of the emitter $P_4$ indicated by 31e to the area $S_1$ of the emitter $P_1$ indicated by 11e can be changed to adjust the ratio $\tau_2/\tau_1$. From the experimental results it is possible to satisfy the condition of $\tau_2/\tau_1 > 0.5$ by making the ratio $S_3/S_1$ larger than 0.25. Although the patterns of the emitters $P_1$ and $P_4$ are formed in a strip-shape here, other patterns such as L-shape, U-shape or the like may be used for the patterns in this embodiment. Moreover, the areas of the emitters $P_1$ and $P_4$ may be made equal and the area ratio $S_4/S_2$ of the collectors $P_2$ and $P_5$ can be selected to be a certain value.

A third approach will next be described in which the condition $\tau_2/\tau_1 > 0.5$ is satisfied by adjusting the ratio of the distance between the emitter $P_1$ and collector $P_2$ of the thyristor 1, and the distance between the emitter $P_4$ and collector $P_5$ of the bipolar transistor 30.

The time constant in the PNP pattern is normally approximately proportional to the square of the base width, or the distance between the two P-regions. Thus, in the strip-

shaped emitters $(P_1)$ 11f and $(P_4)$ 31f of the thyristor 1 and the bipolar transistor 30 as shown in Figures 13A and 13B, by way of example, the emitter $P_1$ of the thyristor 1 and the emitter $P_4$ of the bipolar transistor 30 are made to have the same shape, and the collectors $(P_2)$ 13f and $(P_5)$ 33f also to have the same shape. If the distance between the emitter $P_1$ and collector $P_3$ of the thyristor 1 is represented by $W_1$ and the distance between the emitter $P_4$ and collector $P_5$ of the bipolar transistor 30 by $W_2$, the condition of the $\tau_2/\tau_1 > 0.5$ can be satisfied under the condition, $W_1/W_2 < \sqrt{2}$.

This is also true for L-shaped or U-shaped emitter patterns $P_1$ and $P_4$. As shown in Figures 14A and 14B, when the emitters are of the L-shaped pattern, it is necessary to satisfy the condition, $W_3/W_4 < \sqrt{2}$, where $W_3$ is the distance between the emitter $P_1$ and the collector $P_2$, and the $W_4$ the distance between the emitter $P_4$ and collector $P_5$. Also, as shown in Figures 15A and 15B, when the emitters are U-shaped, it is necessary to satisfy the condition, $W_5/W_6 < \sqrt{2}$ where $W_5$ is the distance between the emitter $(P_1)$ 11h and collector $(P_2)$ 13h, and $W_6$ the distance between the emitter $(P_4)$ 31h and collector $(P_5)$ 33h.

In the above examples, the $P_1N_1P_2$ pattern of the thyristor 1 is the same as the $P_4N_3P_5$ of the bipolar transistor 30. Generally in the PNP pattern where the P-type emitter and the P-type collector have a constant width therebetween and the collector shapes are of the same dimensions, the time constant difference is present under change of emitter shape. The strip-shaped emitter gives the longest time constant, and the L-shaped and U-shaped emitters follow in the order of length of time constant. Thus, a fourth approach for the condition of $\tau_2/\tau_1 > 0.5$ will be mentioned below. If the thyristor 1 and bipolar transistor 30 are designed so that the collectors $P_2$ and $P_5$ have the same dimensions, the width between $P_1$ and $P_2$ equals to that between $P_4$ and $P_5$ and the emitter $P_1$ is shaped in a strip form, and if the emitter $P_4$ is made in an L-shape or U-shape, the condition of $\tau_2/\tau_1 > 1$ can be satisfied.

Moreover, a combination of the first to fourth approaches can be selectively used for proper design of pattern of bipolar transistor 30 to satisfy the condition of $\tau_2/\tau_1 > 0.5$.

Thus, if the elements are constructed to have the similar shape, it is possible to obtain the time constants $\tau_1$ and $\tau_2$ of the thyristor 1 and bipolar transistor 30 the ratio of which is a predetermined value, thereby enabling the gate voltage $V_P$ to be maintained below the gate-cathode built-in voltage $V_B$ of the thyristor and to be prevented from variation. Since the thyristor 1 and bipolar transistor 30 have the same diffusion pattern, the time constant $\tau_2$ is increased or decreased with increase or decrease of the time constant $\tau_1$ due to variation of various conditions so that the ratio of the time constants is kept constant, and thus the peak voltage $V_P$ is almost prevented from change. If the change of the peak voltage $V_P$ is reduced, it may easily be restricted to below a constant value. Thus, this peak voltage is kept below the gate-cathode conduction voltage (about 0.7 V) of the thyristor 1, thereby enabling the production of a semiconductor switch the operation of which is little affected by noise voltage. The occurrence of erroneous operation due to the variation of the characteristics which are inevitable in the prior art are also greatly reduced.

While the above embodiments are the application of the invention to the circuit of Figure 1, the present invention may be applied to the circuits as shown in Figures 16 and 17 which are modifications of Figure 1. In Figures 16 and 17, like elements corresponding to those of Figure 1 are identified by the same reference numerals. In Figure 16, a discharge diode 41 is connected between the base and emitter of the bipolar transistor 30 of Figure 1. The anode of the discharge diode 41 being connected to the base of the bipolar transistor 30. A voltage clamping diode 42 is connected between the base and emitter of the bipolar transistor 21 with the anode connected to the emitter of the bipolar transistor 21. The diode 41 acts to discharge the charge stored in the junction capacitance of the bipolar transistor 30, and the diode 42 acts to prevent a reverse overvoltage from being applied between the base and emitter of the bipolar transistor 21 when a voltage is applied to the anode of the thyristor 1.

In Figure 17, the emitter of the bipolar transistor 30 of Figure 1 is connected to the anode of the thyristor 1 and the base of the bipolar transistor 30 is connected to the N-type base $(N_1)$ 12 of the thyristor 1 through a discharging diode 43. The diode 43 acts to discharge the charge stored in the junction capacitance of the transistor 30.

In the application of the invention to the circuits of Figures 16 and 17, the patterns of the thyristor 1 and bipolar transistor 30 are the same as those of Figures 8A, 8B to 15A, 15B.

Figure 18 shows the combination of two similar circuits one of which is as shown in Figure 17. That is, a thyristor 45 of NPNP structure is added to the arrangement of Figure 17, an NPN bipolar transistor 47 and a resistor 46 are connected in parallel between the gate and anode of the thyristor 45, and the bipolar transistor 47 has its base connected to the emitter of a bidirectional lateral bipolar transistor 30 and a voltage clamping diode 48 connected between the base and emitter thereof. The $N_1$ layer of the thyristor 1 and $N_1$ layer of the thyristor 45 are made of a common N-layer.

In this arrangement, when a positive voltage is applied to the anode A, the current flows into the base of the transistor 21 thereby turning on it through $N_{11}$, $P_{11}$ of the thyristor 45, transistor 47 and bipolar transistor 30. The discharge current flows through the diode 42, transistor 30, diode 43 and $N_1$, $P_1$. When a positive voltage is applied to the cathode K, the current flows into the base of the bipolar transistor 47 thereby turning it on through the diode 42 and transistor 30. In this case, it is necessary that the $P_1N_1P_2$ layer pattern of the thyristor 1 and the pattern of the bipolar transistor 30 be of the same shape or congruent, and that the $P_{12}N_1P_{11}$ layer pattern of the thyristor 45 and the pattern of the bipolar transistor 30 be of the same shape or congruent.

Figure 19 shows a circuit of a semiconductor switch similar to that shown in Figure 1, according to the present invention.

The thyristor 1 is the same as that described previously. In this circuit, when the potential of the anode A is increased with respect to the cathode K, a transient current $i_p$ is flowed through an NPN bipolar transistor 60 consisting of ($N_6$) 63, ($P_7$) 62 and ($N_7$) 61 into a base 72 of a PNP bipolar transistor 70 consisting of ($P_8$) 73, ($N_8$) 72 and ($P_9$) 71. At this instant, the bipolar transistor 70 becomes saturated between the collector 71 and emitter 73, thereby short-circuiting the junction between the N-base 12 and P-emitter 11 of the thyristor 1. That is, Figures 19 and 20 show the circuit arrangement of an embodiment of the invention using a complementary transistor to the transistor of Figure 1.

The structure $N_1P_2N_2$ of the thyristor 1 of Figure 20 and the structure, $N_6P_7N_7$ of the bipolar transistor 60 are congruent or similar to each other as in Figures 8A, 8B to 15A, 15B. In other words, the N-base 12 is congruent or similar to the collector 61, the P-base 13 to the base 62, and the N-emitter 14 to the emitter 63. The pattern of the thyristor 1, bounded by a one-dot chain line is generally congruent or similar to the pattern of the bipolar transistor 60, bounded by one-dot chain line, and therefore the same effect as described previously can be expected.

Thus, according to the invention, the composite PNPN switch of Figure 1, which has been found to be unstable in operation, can have a greatly improved stability, and the design thereof can be performed with simplicity so that the semiconductor switch of the invention is very advantageous in industry.

Another embodiment of the invention will now be described.

Figure 21 shows a circuit arrangement of a composite PNPN switch used. In this case, P-region ($P_{10}$) 80 is provided in the N-base 12 of the thyristor 1 to form a $P_1N_1P_{10}$ structure which performs the same operation as that of the PNP bipolar transistor 30 of Figure 1. The application of the invention to the circuit arrangement of Figure 21 is the pattern structure as shown in Figure 22.

Figure 22 shows a plane, diffused pattern of the thyristor 1 in Figure 21, in which the $P_1$ region 11 is the anode region. Inside the anode region 11, there are the P-base 13, N-emitter 14 and the region 80 corresponding to the collector.

As is evident from the pattern, the PNP ($P_1N_1P_2$) of the thyristor 1 and the PNP ($P_1N_1P_{10}$) of the equivalent transistor are symmetrical with respect to the one-dot chain line as shown and their patters are considered to be congruent or similar to each other as in Figures 8A, 8B to 15A, 15B. Therefore, the equal or similar characteristics can be fully expected in both the PNP structures to which the present invention is applied.

While in the previous embodiments circuit elements such as thyristor, transistor and the like are integrated in a dielectric isolation separating substrate, such elements may be integrated in a known PN junction isolation separating substrate or air isolation separating substrate. Moreover, the present invention can be used not only for the monolithic integrated circuit but for the discrete-type integrated circuit.

Moreover, while in the above embodiments of Figures 19 and 21 a minimum number of elements necessary for a semiconductor switch are used for simplicity of explanation, other various circuit elements such as diodes can be incorporated therein according to different specification as in Figures 16 and 17.

Furthermore, other approaches for satisfying the condition of $\tau_2/\tau_1 > 0.5$ can be used instead of making cimilar or congruent plane diffused pattern; for example, adjusting the depth of P, N layer of the bipolar transistor and thyristor to control the time constants, or controlling the time constants of the thyristor and transistor by bombardment of electron beam with the depth of P, N layer kept the same.

**Claims**

1. A semiconductor switch comprising:

a thyristor (1) comprising four semiconductor layers PNPN having three PN junctions and anode, cathode and gate electrodes;
a first bipolar transistor (21, 70) for short circuiting the PN junction between one of the outer semiconductor layers and the adjacent intermediate layer of the thyristor upon saturation of the first bipolar transistor; and
a second bipolar transistor provided between the base of the first bipolar transistor and the other other layer and/or the intermediate layer adjacent said other outer layer of the thyristor so as to saturate said first bipolar transistor in accordance with the voltage which is applied to said other outer layer of the thyristor and which increases the potential of the anode relative to the cathode; characterised in that:
the structure of the second bipolar transistor and a third bipolar transistor consisting of said other outer layer and the two intermediate layers of the thyristor is such that the ratio of the carrier fall time constant of the second and third bipolar transistors is not substantially less than 0.5, thereby to prevent the semiconductor switch from erroneous firing.

2. A semiconductor switch according to claim 1, wherein said thyristor is of four-layer PNPN structure toward said cathode from said anode, said first bipolar transistor (21) is of three-layer NPN structure, said second bipolar transistor (30) is of three-layer PNP structure and said third bipolar transistor is formed by the three continuous layers PNP of said thyristor of PNPN structure.

3. A semiconductor switch according to claim 1, wherein said thyristor is of four-layer PNPN structure toward said cathode from said anode, said first bipolar transistor (70) is of three-layer PNP structure, said second bipolar transistor (60) is of three layer NPN structure, and said third bipolar transistor is formed by the three continuous layers PNP of said thyristor.

4. A semiconductor switch according to claim 1, wherein a first one of the intermediate layers of the four semiconductor layers of said thyristor is provided with the gate electrode, the second of the intermediate layers is provided with a fifth semiconductor layer (80) the conductivity type of which is different from that of the said second intermediate layer, so that the end layer of said thyristor adjacent to said second intermediate layer, together with the said second intermediate layer and the fifth semiconductor layer constitutes said second bipolar transistor, said third bipolar transistor being formed by said end layer of the thyristor and the said two intermediate layers.

5. A semiconductor switch according to any one of claims 1 to 4, wherein the plane diffused pattern of the emitter and collector of the third bipolar transistor is similar in location and/or spacing to that of the second bipolar transistor.

6. A semiconductor switch according to any one of claims 1 to 5, wherein said second and third bipolar transistors have the same plane diffused pattern, and the time constant of said thyristor equals that of said second bipolar transistor.

7. A semiconductor switch according to any one of claims 2 to 5, wherein the emitters of said second and third bipolar transistors have an elongate shape in their plane diffused patterns, and the ratio of the length of the emitter of said second bipolar transistor to that of said third bipolar transistor is substantially 0.2 or above.

8. A semiconductor switch according to any one of claims 1 to 5, wherein in the plane diffused patterns of said second and third bipolar transistors, the ratio of the emitter area of said second bipolar transistor to that of said third bipolar transistor is substantially 0.25 or above.

9. A semiconductor switch according to any one of claims 1 to 5 wherein in the plane diffused patterns of said second and third bipolar transistors, the ratio of the base width of said second bipolar transistor to that of said third bipolar transistor is substantially $1/\sqrt{2}$ or above.

10. A semiconductor switch according to any one of claims 1 to 5, wherein in the plane diffused patterns of said second and third bipolar transistors, the emitter of said third bipolar transistor has an elongate shape and the emitter of said second bipolar transistor has an L-shape or U-shape.

**Patentansprüche**

1. Halbleiterschalter, umfassend:

einen Thyristor (1) umfassend vier Halbleiterschichten PNPN mit drei PN-Übergängen sowie Anoden-, Kathoden- und Steuerelektroden;

einen ersten Bipolartransistor (21, 70) zum Kurzschließen des PN-Übergangs zwischen einer der äußeren Halbleiterschichten und der benachbarten Zwischenschicht des Thyristors bei Sättigung des ersten Bipolartransistors; und

einen zweiten Bipolartransistor, der zwischen der Basis des ersten Bipolartransistors und der anderen äußeren Schicht und/oder der dieser anderen äußeren Schicht benachbarten Zwischenschicht des Thyristors vorgesehen ist, um den ersten Bipolartransistor entsprechend der and der besagten anderen äußeren Schicht des Thyristors anliegenden Spannung zu sättigen, und der das Potential der Anode, bezogen auf die Kathode, erhöht; dadurch gekennzeichnet, daß

der Aufbau des zweiten Bipolartransistors und eines aus der besagten anderen äußeren Schicht und den beiden Zwischenschichten des Thyristors bestehenden dritten Bipolartransistors derart ist, daß das Verhältnis der Ladungsträgerabfall-Zeitkonstanten des zweiten und des dritten Bipolartransistors nicht wesentlich kleiner ist als 0,5, um fehlerhafte Zündung des Halbleiterschalters zu verhindern.

2. Halbleiterschalter nach Anspruch 1, wobei der Thyristor einen Vierschicht-PNPN-Aufbau von der Anode zur Kathode hat, der erste Bipolartransistor (21) einen Dreischicht-NPN-Aufbau, der zweite Bipolartransistor (30) einen Dreischicht-PNP-Aufbau, und wobei der dritte Bipolartransistor von den drei aufeinanderfolgenden Schichten PNP des Thyristors mit dem PNPN-Aufbau gebildet ist.

3. Halbleiterschalter nach Anspruch 1, wobei der Thyristor einen Vierschicht-PNPN-Aufbau von der Anode zur Kathode hat, der erste Bipolartransistor (70) einen Dreischicht-PNP-Aufbau, der zweite Bipolartransistor (60) einen Dreischt-NPN-Aufbau, und wobei der dritte Bipolartranssistor von den drei aufeinanderfolgenden Schichten NPN des Thyristors gebildet ist.

4. Halbleiterschalter nach Anspruch 1, wobei eine erste der Zwischenschichten der vier Halbleiterschichten des Thyristors mit der Steuerelektrode und die zweite der Zwischenschichten mit einer fünften Halbleiterschicht (80) versehen ist, deren Leitfähigkeitstyp von dem der zweiten Zwischenschicht verschieden ist, so daß die der zweiten Zwischenschicht benachbarte Endschicht des Thyristors zusammen mit der zweiten Zwischenschicht und der fünften Halbleiterschicht den zweiten Bipolartransistor bildet, und wobei der dritte Bipolartransistor von der besagten Endschicht des Thyristors und den beiden Zwischenschichten gebildet ist.

5. Halbleiterschalter nach einem der Ansprüche 1 bis 4, wobei das ebene Diffusionsmuster von Emitter und Kollektor des dritten Bipolartransistors hinsichtlich Ort und/oder Abstand dem des zweiten Bipolartransistors ähnlich ist.

6. Halbleiterschalter nach einem der Ansprüche 1 bis 5, wobei der zweite und der dritte Bipolartransistor das gleiche ebene Diffusionsmuster aufweisen und die Zeitkonstante des Thyristors gleich der des zweiten Bipolartransistors ist.

7. Halbleitherschalter nach einem der Ansprüche 2 bis 5, wobei die Emitter des zweiten und des dritten Bipolartransistors in ihren ebenen Diffusionsmustern eine längliche Form haben und das Verhältnis der Emitterlänge des zweiten Bipolartransistors zu der des dritten Bipolartransistors im wesentlichen 0,2 oder mehr beträgt.

8. Halbleiterschalter nach einem der Ansprüche 1 bis 5, wobei in dem ebenen Diffusionsmustern des zweiten und des dritten Bipolartransistors das Verhältnis der Emitterfläche des zweiten Bipolartransistors zu der des dritten Bipolartransistors im wesentlichen 0,25 oder mehr beträgt.

9. Halbleiterschalter nach einem der Ansprüche 1 bis 5, wobei in den ebenen Diffusionsmustern des zweiten und des dritten Bipolartransistors das Verhältnis der Basisbreite des zweiten Bipolartransistors zu der des dritten Bipolartransistors in wesentlichen $1/\sqrt{2}$ oder mehr beträgt.

10. Halbleiterschalter nach einem der Ansprüche 1 bis 5, wobei in den ebenen Diffusionsmusters des zweiten und des dritten Bipolartransistors der Emitter des dritten Bipolartransistors eine längliche Form hat und der Emitter des zweiten Bipolartransistors L- oder U-förmig ist.

**Revendications**

1. Commutateur à semiconducteurs comprenant:

un thyristor (1) comprenant quatre couches semiconductrices PNPN possédant trois jonctions PN et des électrodes d'anode, de cathode et de grille;

un premier transistor bipolaire (21, 70) servant à court-circuiter la jonction PN entre l'une des couches semiconductrices extérieure et la couche intermédiaire adjacente du thyristor lors de la saturation du transistor bipolaire; et

un second transistor bipolaire prévu entre la base du premier transistor bipolaire et l'autre couche extérieure et/ou la couche intermédiaire adjacente à ladite autre couche extérieure du thyristor de manière à saturer ledit premier transistor bipolaire en fonction de la tension qui est appliquée à ladite autre couche du thyristor et qui augmente le potentiel de l'anode par rapport à la cathode, caractérise en ce que:

la structure du second transistor bipolaire et d'un troisième transistor bipolaire constitué par ladite autre couche extérieure et les deux couches intermédiaires du thyristor est telle que le rapport des constantes de temps de décroissance des porteurs du second et du troisième transistor bipolaire n'est pas sensiblement inférieure à 0,5, ce qui permet d'empêcher un déclenchement erroné du commutateur à semiconducteurs.

2. Commutateur à semiconducteurs selon la revendication 1, dans lequel ledit thyristor est une structure à quatre couches PNPN s'étageant depuis l'anode en direction de la cathode, ledit premier transistor bipolaire (21) est une structure à trois couches NPN, ledit second transistor bipolaire (30) est une structure à trois couches NPNP et ledit troisième transistor bipolaire est constitué par les trois couches continues PNP dudit thyristor possédant la structure NPN.

3. Commutateur à semiconducteurs selon la revendication 1, dans lequel ledit thyristor est une structure à quatre couches PNPN s'étageant de l'anode vers la cathode, ledit premier transistor bipolaire (70) est une structure à trois couches PNPN, ledit second transistor bipolaire (60) est une structure à trois couches NPN et ledit premier transistor bipolaire est constitué par les trois couches continues NPN du dudit thyristor.

4. Commutateur à semiconducteurs selon la revendication 1, dans lequel la première des couches intermédiaires des quatre couches semiconductrices dudit thyristor est munie de l'électrode de grille, la second desdites couches intermédiaires est équipée d'une cinquième couche semiconductrice (80), dont le type de conductivité est différent de celui de ladite seconde couche intermédiaire de telle sorte que la couche d'extrémité dudit thyristor, adjacente à ladite seconde couche intermédiaire, ainsi qui ladite seconde couche intermédiaire et la troisième couche semiconductrice constituent ledit second transistor bipolaire, ledit troisième transistor bipolaire étant formé par ladite couche d'extrémité du thyristor et par lesdites deux couches intermédiaires.

5. Commutateur à semiconducteurs selon l'une quelconque des revendications 1 à 4, dans lequel la configuration diffusée plane de l'émetteur et du collecteur du troisième transistor bipolaire est semblable, du point de vue position et/ou espacement, à celle du second transistor bipolaire.

6. Commutateur à semiconducteurs selon l'une quelconque des revendications 1 à 5, dans lequel ledit second et ledit troisième transistor bipolaire possède la même configuration diffusée plane, et la constante de temps dudit thyristor est égale à celle dudit second transistor bipolaire.

7. Commutateur à semiconducteurs selon l'une quelconque des revendications 1 à 5, dans lequel les émetteurs desdits second et troisième transistors bipolaires possédant une forme allongée dans leur configuration diffusée plane, et le rapport de la longueur de l'émetteur dudit second transistor bipolaire à celle dudit troisième transistor bipolaire est essentiellement égale à 0,2 ou plus.

8. Commutateur à semiconducteurs selon l'une quelconque des revendications 1 à 5, dans lequel dans les configurations diffusée planes desdits second et troisième transistors bipolaires, le rapport de la surface d'émetteur dudit second transistor bipolaire à la surface d'émetteur dudit troisième transistor bipolaire est essentiellement égale à 0,25 ou plus.

9. Commutateur à semiconducteurs selon l'une quelconque des revendications 1 à 5, dans lequel les configurations diffusées planes dudit second et troisième transistor bipolaire, le rapport de la largeur de de la base dudit second transistor bipolaire à la largeur de la base dudit troisième transistor bipolaire est essentiellement égale à $1/\sqrt{2}$ ou plus.

10. Commutateur à semiconducteurs selon l'une quelconque des revendications 1 à 5, dans lequel dans les configurations diffusées planes desdits second et troisième transistor bipolaires l'émetteur dudit troisième transistor bipolaire possède une forme allongée et l'émetteur dudit second transistor bipolaire possède une forme de L ou de U.

## FIG. 1  PRIOR ART

## FIG. 2

## FIG. 3

1

FIG. 4

FIG. 5

FIG. 6 PRIOR ART

## FIG. 7A

101  11  12  14  13

P₁  N₂  P₂

N₁

35

110

## FIG. 7B

130  31  32  33

P₄  P₅

N₃

36

110

## FIG. 8A

101

P₁  11a

N₁  12

N₂  P₂

35  14a

13a

110

## FIG. 8B

103

P₄  31a

N₃  32

P₅

33a  36

110

## FIG. 9

P₅  33b

P₄  N₃

32

31b

## FIG. 10

33c

P₅  32

P₄  N₃

31c

FIG. 11A

FIG. 11B

FIG. 12A

FIG. 12B

FIG. 13A

FIG. 13B

FIG. 14A

FIG. 14B

4

FIG. 15A

FIG. 15B

FIG. 16

FIG. 17

FIG. 18

5

FIG. 19
PRIOR ART

FIG. 20

FIG. 21
PRIOR ART

FIG. 22